# EUROPEAN PATENT APPLICATION

(11) **EP 4 513 710 A2**
(43) Date of publication of application: **26.02.2025**
(21) Application number: 24187580.6
(22) Date of filing: 10.07.2024
(51) Int. Cl.: H02J 7/00, B60L 58/19, B60L 58/21, G01R 31/392, H01M 10/44, H01M 10/48

(54) **BATTERY STORAGE SYSTEM AND METHOD FOR PROVIDING ENHANCED BATTERY LIFETIME**

(30) Priority: 22.08.2023 EP 23192664
(71) Applicant: STABL Energy GmbH, 81379 München (DE)
(72) Inventor: SINGER, Arthur, 81379 München (DE); FÖRSTER, Thomas, 81379 München (DE)
(74) Representative: Lohr, Jöstingmeier & Partner

(57) **Abstract**

A method of operating a battery storage system having at least one multilevel converter with a plurality of battery modules includes the steps of: selecting at least one battery module out of the plurality of battery modules, setting the selected battery module in a bypass state for a specified time interval between 1 second and 30 days or between 5 minutes and 20 days, while maintaining multi-level converter operation, and releasing the selected battery module from the bypass state.

## Description

### Field of the invention

The invention relates to a battery storage system using multilevel converters and to a Method for providing an enhanced battery lifetime.

### Description of the related art

US 2014/0049230 A1 discloses a multilevel converter topology for generating AC signals by switching multiple batteries.

US 2013/0234667 A1 discloses a battery management system, where each battery management unit includes a battery cell, an isolation element, and a bypass element. This allows to activate or isolate individual battery cells.

### Summary of the invention

The problem to be solved by the invention is to provide a battery storage system, where the batteries have a longer lifetime compared to known battery storage systems. Further, a method should be provided for increasing lifetime of batteries within a battery storage system, but without interruption of the operation of the battery system.

Solutions of the problem are described in the independent claims. The dependent claims relate to further improvements of the invention.

In an embodiment, a method of operating a battery storage system is based on a battery storage system comprising at least one multilevel converter (MLC). Such a multilevel converter includes a plurality of battery modules, where each of the plurality of battery modules includes at least one battery. The at least one multi-level converter is configured for multilevel converter mode (MLC mode) including at least one of delivering electrical power by discharging at least one battery and/or receiving electrical power by charging at least one battery. This also includes that for short periods of time, e.g., when a sine wave passes zero, no battery module may be connected and such no batter is charged or discharged. The electrical power may be delivered to a load, e.g., a power grid, battery, motor or current consumer. Further, the electrical power may be received from a source, e.g., power grid, battery, motor/generator or power plant.

The method comprises at least the steps of:
a) randomly selecting at least one battery module out of the plurality of battery modules,
b) setting the at least one selected battery module in a bypass state for a specified time interval between 1 second and 30 days or between 5 minutes and 10 days (herein referred as rest state), while maintaining multilevel converter mode. Multilevel converter mode may be maintained by using the remaining battery modules.
c) releasing the selected battery module from the bypass state. Therefore, multilevel converter mode may be continued with using the at least one selected battery module again.

In an alternative, but very similar method the same problem is solved by performing at least the following steps. Here, the at least one multilevel converter is configured for multilevel converter mode by using a subset of the plurality of batteries. The steps include:
a) randomly selecting at least one battery module out of the subset,
b) removing the at least one selected battery module from the subset for a specified time interval between 1 second and 30 days or between 5 minutes and 10 days, while maintaining multilevel converter mode with the battery modules of the remaining subset,
c) re-inserting the selected battery module into the subset and continuing maintaining multilevel converter mode with the subset,
while the at least one multilevel converter is configured for multilevel converter mode including at least one of delivering electrical power by discharging at least one battery and/or receiving electrical power by charging at least one battery, by using a subset of the plurality of batteries.

Both methods allow for a specific handling or treatment of a battery in a selected battery module without affecting normal operation of the multilevel converter (MLC). Therefore, the MLC may switch any required number of batteries together to dynamically obtain a required output voltage and/or current, which may e.g., have a sine wave. Whereas the MLC mode includes This works as long as the remaining number of battery modules is large enough to provide a required voltage and/or current.

Randomly selecting may be performed e.g. by assigning a random number to each battery module and selecting the battery module with the highest or lowest number. This may result in equal probabilities for all battery modules such that after some time every battery may have been selected.

These methods are using a specific property of a multilevel converter, namely, that the battery modules are in a series connection and all battery modules always share the same current. In multilevel converters batteries in selected modules can be bypassed, such that no current is flowing through the battery. Those modules can be put to rest or rest state for a defined time (rest period) to harvest chemical side reactions (or to let them settle/relax). This may be used for more precise measurements of battery properties and/or for allowing the batteries to rest for a certain time, which has shown to increase the useful lifetime of a battery. For example, a battery that has a 2-day rest period every 50 cycles may reach twice the number of full cycles compared to a battery which has no rest cycles. Also pulsing a battery with 2C rate, 50% duty cycle at a frequency of 0,05Hz may increase lifetime by more than 70% instead of cycling the battery with 1C.

Further, during such a pause more precise measurements of battery properties, e.g., battery voltage or temperature may be performed, which allow for a better battery management and/or battery analytics, which can be used to further increases lifetime. For more precise measurements it can be enough to pause the usage of a module for shorter amounts of time, e.g., down to 1-10 seconds.

The following embodiments and modifications generally refer to both methods.

The selection of the battery modules may be made from a group of battery modules which
- had no rest time during a specific time interval,
- had lower rest time than other batteries,
- have higher use than other batteries,
- have lower SOH (State of Health) than other batteries.

The selection of at least one battery module of step a) may be made by different ways and/or based on different preconditions. Step a) may be at least one of:
- selecting at least one battery module based on a table. The table may be filled with battery specific data, e.g., at least one of: state of health (SOH), state of charge (SOC), temperature, number of previous selections.
- selecting at least one battery module based on at least one of battery size, battery type, battery age. This may allow to preselect different groups of batteries having some common properties.
- selecting at least one battery module based on a list and a pointer to a line in this list which is advancing by one step after a certain amount of time (e.g., Round Robin)

The steps a) to c) may be repeated until a certain amount of plurality of battery modules or the subset have been selected.

The method steps a) to c) may be repeated continuously, such that after step c), a new sequence with step a) starts. There may be a pause in between.

There may be an additional step of predicting a next time window for performing the method or at least steps b) and optionally c), as these steps limit the overall capability of a multilevel converter, because then the multilevel converter has to operate with at least one battery module less. Generally, step a) may be executed some time ahead steps b) and c). Prediction may be based on load of the battery system, such that step b) falls in a time with low load to the battery storage system, e.g., at night. The additional step max be executed before any step b).

There may be multiple processes performing the method simultaneously, e.g., at a fast rate and at a slow rate. Repeatedly executing the method at a slow rate, e.g., every few hours, may allow to have longer specified time intervals, while in parallel executing the method at a high rate, e.g., every minute, may allow for precise measurements, e.g., of a battery voltage during these periods.

The method may be performed for multiple batteries at the same time. In a three-phase system with three strings this method may be performed per string independently from the other strings and for multiple batteries per string at the same time.

Besides measuring at least one battery voltage during or after step b) and before step c), the battery may be charged or discharged to a predetermined state of charge. Further positive and/or negative current pulses may be given to the at least one battery.

For step c) the selection of the specified time interval may be made based on the following:
When a battery is loaded with a current, measuring its voltage is no longer precise, since there are current dependent voltage drops on its poles. Those voltage drops are not only current dependent but also time dependent, since the battery is a chemical system and has long-term chemical reactions ongoing. It has been shown that those long-term chemical reactions can be detectable as long as 48h after the last current load. Those reactions need time to relax, so that no more unwanted voltage deviations skew the measurement result. A time constant for relaxation for most chemical reactions may be in the range 15-30 minutes. To compensate for imprecisions because of current flow, a range of 1-10 seconds may be sufficient.

It is believed that giving batteries the specified time intervals as rest periods will decrease their capacity fade or even reclaim lost capacity (most probably due to lithium plating) and therefore giving a longer effective lifetime. Those rest periods typically are longer than the periods mentioned above. Depending on the length of the rest period, different effects (and probably chemical reactions) will take place. There may be short rest periods e.g., every 10 sec for 10 seconds (50% duty cycle, PWM with 2C and 0,05Hz). Further, there may be longer rest periods between 1 hour and 10 hours, typically 4 hours. A further effect is achieved with longer rest periods of more than one day up to 10 days or 20 days or days, e.g., 5 days. Normal battery storage systems have to be switched off or have to stop their operation for such rest periods.

In the embodiments disclosed herein, the battery storage system can continue normal operation, as only one or a low number of batteries is in a rest period, as long as the remaining batteries can maintain proper operation.

In those time frames different chemical reactions take place. Using the invention, basically those reactions can be examined, and their effects can be measured.

An embodiment includes repeating the sequence of steps a) to c) until at least a predetermined number, 80%, 90% or 95% or all of the plurality of battery modules has been selected.

In another embodiment, the bypass state may be interrupted by switching the selected battery module into a connected state for at least one short time interval to generate short positive or negative current pulses through a battery in the battery module.

In an embodiment, the method comprises during or after step a) and before step b):
Discharging or charging the selected battery module to a predefined state of charge (SOC) (e.g., a SOC below 60% or a SOC at about 30%), so that the resting period may start at the pre-defined SOC or maintains the pre-defined SOC for a certain time.

For performing the method above, a battery module may include a battery, a series switch configured to connect or disconnect the battery within the battery module, and a parallel switch configured to bypass the battery module when closed. Further, the battery module may be configured for a connected state where the series switch is open, and the parallel switch is closed, and a bypass state, where the series switch is open, and the parallel switch is closed.

In an embodiment, a battery storage system includes a plurality of battery modules, wherein each module includes a switch which is configured, when closed, to connect a module's battery in series with other batteries and/or modules, called a connected state. The switch, which may be a series switch, may also be configured to isolate the battery from other batteries and/or modules when open. There may be a parallel switch at the battery module for bypassing the battery module when closed. This state is called a bypass state. If both switches are open, the battery module is in an open state. There may be a higher number of switches, which may provide further switching states (e.g., a state which allows one battery to be connected in parallel with another battery). A battery may include one or more battery cells. For high power applications groups of battery cells may be connected in series (e.g., hard-wired) in order to have a higher voltage.

An integer number of N with N >=2 modules may be connected to a string. A battery storage system may comprise at least one string. Further, an integer number M with M >=2 strings may be connected together. Individual strings may have individual numbers N1, N2, N3, ... of modules. The strings may be connected together by a parallel circuit. A string may include an inductor and/or a diode to improve current distribution and/or to avoid unwanted currents flowing between strings. An inductor may improve current control of a string as the current may be controlled by pulse width modulation (PWM) switching between the connected and open states of a string. The inductor may also include connecting cables of sufficient length. The battery storage system may be configured for delivering a DC voltage to a load. It may also be configured for delivering an AC voltage by approximating a sinusoidal or any other waveform by switching varying numbers of battery modules in a connected state.

A string may be configured to provide balancing of its battery modules. Normally, the number N of battery modules within a string is selected, such that the string may provide a higher output voltage than its nominal output voltage. Therefore, normally, not all battery modules are required to each provide a nominal output voltage and not all battery modules are in a connected state. The remaining battery modules are in a bypass state and do not deliver power, such that only the batteries of the connected battery modules will be discharged while the batteries of the modules in bypass state keep their charge. For balancing the battery modules, over time, the battery modules in a string may be configured to different states, e.g., from connected state to bypass state or from bypass state to connected state, such that all batteries are discharged to a common power state, e.g., state of charge. The battery storage system may be configured to select within a string over multiple periods of time/and or time intervals different combinations of battery modules for a connected state while the remaining battery modules are in a bypass state. During discharging of the battery storage system, at least one of the battery modules with a higher power state may have longer times in a connected state than at least one of the battery modules with a lower power state.

Basically, the same applies if the battery modules of a string are charged. Here, the states of the battery modules may be exchanged from time to time such that all battery modules have a similar or the same power state. During charging of the battery storage system, at least one of the battery modules with a lower power state may have longer times in a connected state than at least one of the battery modules with a higher power state.

In another embodiment, with the at least one selected battery module being in rest state including a bypass state, tests and measurements may be made. In a specific embodiment, the temperature of a battery module being in rest state may be monitored from the beginning of the rest state. The decrease in temperature may be evaluated. This may be done until the temperature change has been settled to a predetermined value. For this purpose, the battery module may have at least one temperature sensor. During the rest state, the temperature may decrease to an ambient temperature. With the information from this cooldown temperature profile a thermal model can be obtained.

As an additional or alternative step when in rest state one or more further rested battery modules may be put in a connected state for short time intervals, generating pulses with sequential positive and negative pulse currents, wherein one or more of those pulses result in net zero charge transfer. During keeping MLC operation with the other battery modules - amplitude of positive and negative pulses as well as duration and of pulses must be the same. With an even number of paused battery modules these pulses can be done in a way that they do not have an effect on the output voltage, independent of the MLCs operation. With the help of these pulses the thermal response on a specified charge transfer can be observed and the thermal model can be calculated or verified. Based on the thermal model and the temperature increase during the energy pulses the battery health and/or internal battery losses can be estimated from measured battery temperature and/or voltage values without stopping MLC operation.

A further embodiment relates to a method and device for controlling a multilevel converter which is connected to a power grid. This embodiment provides an excellent control while reducing the amount of processing power, such that the control can be implemented with comparatively simple and inexpensive microcontrollers. The control device or method may be implemented as software on a memory device and may be executed by a microcontroller or microprocessor. The control device or method controls a multilevel converter being connected to a power grid or any other load/source herein referred to as grid. The control further includes a grid voltage filter and a current controller. The current controller receives a measured grid current and/or output current of the multilevel converter. It further receives a current set point from which it generates a current controller output. The grid voltage filter receives a measured grid voltage and/or an output voltage of the multilevel converter and generates a grid voltage estimate including a direct component and its quadrature component. The direct component, which is used as a feedforward compensation term, is added e.g., by a summing node to the current controller output and fed to the multilevel converter. This feedforward term reduces the workload of the microcontroller and increases the overall bandwidth of the current controller. In case multiple harmonics are observed, the feedforward term even serves as a means to reduce harmonics in the multilevel converter output current.

### Description of Drawings

In the following the invention will be described by way of example, without limitation of the general inventive concept, on examples of embodiment with reference to the drawings.
Fig. 1 shows a circuit diagram of an embodiment.
Fig. 2 shows a block diagram of a battery storage system.
Fig. 3 shows details of a battery module.
Fig. 4 shows an open switching state of battery modules in detail.
Fig. 5 shows a connected switching state of battery modules in detail.
Fig. 6 shows a bypass switching state of battery modules in detail.
Fig. 7 shows a flow diagram of a method.
Fig. 8 shows a first SOC curve of a selected battery.
Fig. 9 shows a second SOC curve of a selected battery.
Fig. 10 shows a third SOC curve of a selected battery.
Fig. 11 shows an embodiment of a multilevel converter control.
Fig. 12 shows a timing diagram of battery parameters when performing a test during a rest period.

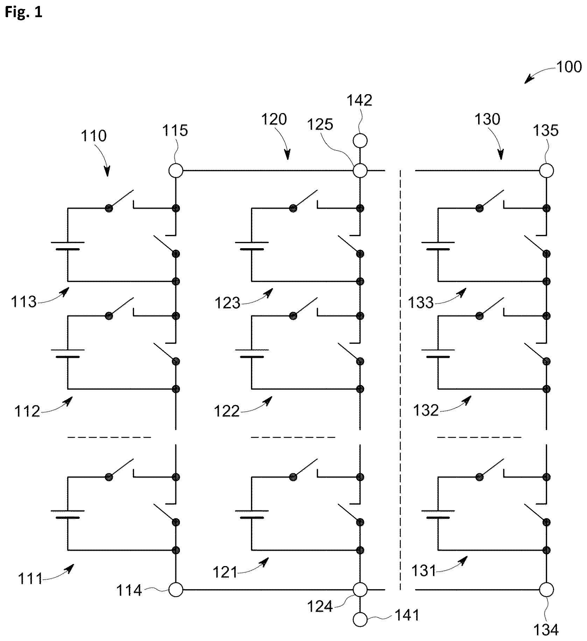

Fig. 1 shows a circuit diagram of an embodiment of a battery storage system 100. The battery storage system 100 includes a plurality of strings of battery modules. This figure shows three strings 110, 120, 130 which are connected in parallel. There may also be two strings or any higher number of strings.

Each string of battery modules 110, 120, 130 includes a plurality of battery modules which may be connected in series. Herein, exemplary three battery modules are shown. Instead, there may be at least two battery modules and any higher number of battery modules. Each battery module may include at least a battery, one switch for disconnecting the battery and another switch for bridging the battery module. In this figure, a first string 110 includes three battery modules 111, 112, 113 which are connected in series. The first string may have a first connector 114 connected to the first battery module 111 and a second connector 115 connected to the last battery module of the string which is the third battery module 113 in this embodiment. The same applies to the second string 120 including battery modules 121, 122 and 123 which are connected to a first connector of second string 124 and a second connector of second string 125. The third string 130 includes battery modules 131, 132 and 133 which are connected to first connector of third string 134 and second connector of third string 135.

The first connectors 114, 124 and 134 may be connected together to a common first battery storage system connector. Further, the second connectors 115, 125 and 135 may also be connected together to a second battery system connector 142. In this embodiment, the battery storage system 100 may deliver power at the first battery system connector 141 and the second system battery connector 142. The battery storage system 100 may also be charged through these connectors.

Each string may be configured to provide different output voltages by connecting any number of batteries in series. If no battery is connected, then the output voltage may be zero. There may also be a high impedance, if at least one battery module is in an open state.

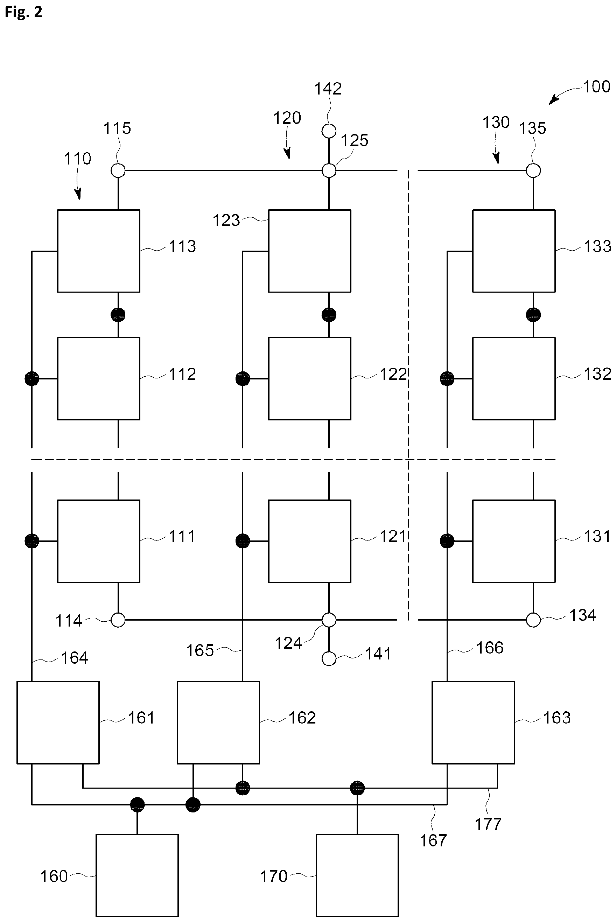

Fig. 2 shows a block diagram of a battery storage system 100. The individual battery modules are shown as blocks. Further, control means are shown. A first string controller 161 may control via a control bus 164 the battery modules of the first string 111, 112 and 113. As the individual battery modules of a string may be on varying potentials depending on the switching states of the battery modules, there must be an isolation to the bus. This may be done by isolated bus couplers in the battery modules. Alternatively, individual isolated bus lines may be provided between a string controller and the battery modules of a string.

String 2 is controlled by second string controller 162 via second control bus 165 and string 3 is controlled by third string controller 163 via third control bus 166.

The string controllers may be controlled by a master controller 160 via a master control bus 167. Alternatively, there may be a single controller including the functions of master controller and string controllers. A plurality of individual string controllers which may operate independently, and which further may operate autonomously may increase the reliability of the system. In the case, the master controller would fail, the individual string controllers may revert to a previous configuration or to a standard failsafe configuration. The module controllers and/or the master controller form a controller structure.

There may also be a backup master controller 170 which may communicate with the string controllers via a backup master control bus 177. There may also be backup string controllers and/or a backup control bus within the strings.

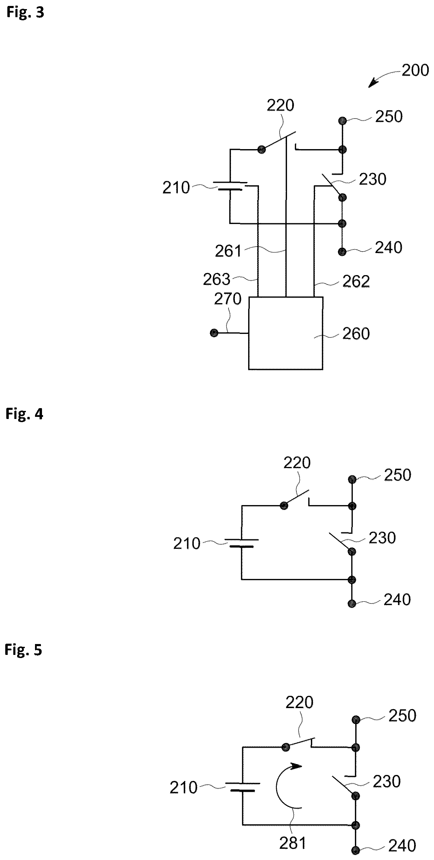

Fig. 3 shows details of a battery module 200. Each of the previously shown individual battery modules 111-113, 121-123 and 131-133 may have the same or a similar structure. A battery module 200 may include a battery 210. Such a battery may be any source of electrical DC power. Normally, such a battery may be based on a rechargeable technology, like LiPo, LiFe, Li-Ion, NiCd, NiMH. It may also include a fuel cell. The battery module 200 may further include a series switch 220 which may be connected in series to the battery, and which may be configured to connect or to disconnect the battery for providing a disconnected state in which the battery is isolated from other batteries. If the series switch 220 is closed, the battery is in a connected state. The battery 210 together with the series switch 220 may be connected between a first module connector 240 and a second module connector 250. In the embodiment shown, the positive pole (+) of a battery is connected to the second module connector 250 whereas the negative (-) pole of a battery is connected to the first module connector 240. There may further be a parallel switch 230 which may also be connected between the first module connector 240 and the second module connector 250. The parallel switch 230 may be configured to provide a short-circuit between the first module connector 240 and the second module connector 250 in a closed state which is called the bypass state herein. When the parallel switch 230 is closed, the series switch 220 may be opened to avoid a short-circuit of the battery. The battery module 200 may further be configured to provide an open state, where the series switch 220 and the parallel switch 230 are open. In such a state, no current can flow through the battery module and therefore through the string in which the battery module is integrated. This means, that the string is disconnected from the other strings in the battery storage system.

Summarizing, there may be three different states of the battery storage system 100, a connected state, a bypass state and an open state.

For controlling the switches, a module controller 260 may be provided. This module controller 260 may control the series switch 220 via a series switch control line 261. It may further control the parallel switch 230 by a parallel switch control line 262. There may also be a battery signal line or a bus 263 for receiving battery parameters like battery temperature, battery voltage, battery current or state of charge or state of health. Based on these parameters, the module controller may control the switches.

The module controller 260 may be connected by a bus connector 270 to a control bus of a string controller. The module controller may receive commands for controlling the switch from the string controller and may forward status information of switches and/or battery to the string controller.
Fig. 4 shows an open switching state of battery modules in detail. The series switch 220 and the parallel switch 230 are open.
Fig. 5 shows a connected switching state of battery modules in detail. The series switch 220 is closed and the parallel switch 230 is open. This allows current to flow in direction 281 if the battery is discharged. For charging the battery, the current is flowing in an opposite direction.

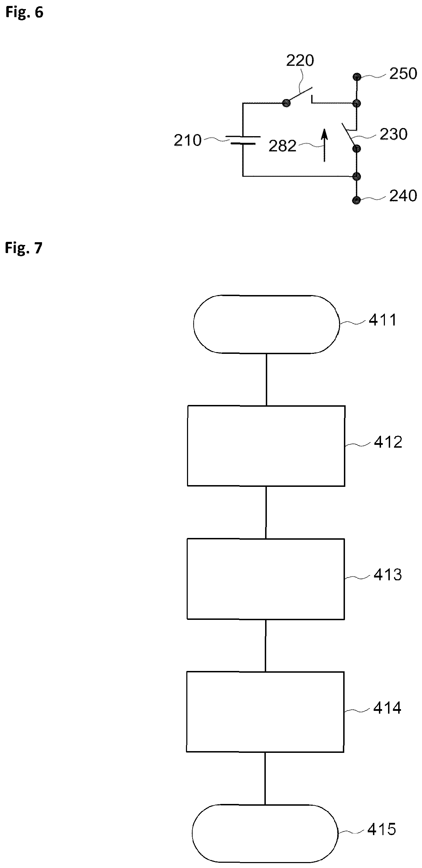

Fig. 6 shows a bypass switching state of battery modules in detail. The series switch 220 is open and the parallel switch 230 is closed. This may allow current to flow in a direction 282 or opposite thereto.
Fig. 7 shows a flow diagram of a method. The method starts in 411.

The first step 412 is selecting at least one battery module out of the plurality of battery modules.

The second step 413 is setting the at least one selected battery module in a bypass state for a specified time interval between 1 second and 30 days or between 5 minutes and 10 days, while maintaining multilevel converter mode with the remaining modules.

The third step 414 is releasing the selected battery module from the bypass state.

The method ends in 415.

First, second and third method steps may be repeated in sequence. The steps may also be performed simultaneously with different selected battery modules.

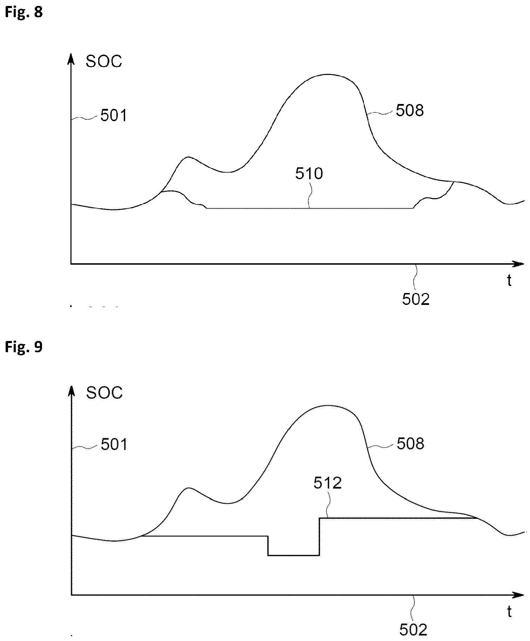

Fig. 8 shows a first exemplary SOC (state of charge) curve 510 of a selected battery module together with at least one remaining battery module's SOC curve 508. During normal multilevel converter mode or operation, the battery modules may have varying states of charges (SOC) as exemplarily shown by curve 508. An at least one selected battery module may have a constant SOC during method step b)

Fig. 9 shows a second exemplary SOC curve 512 of a selected battery module. Here, during step b) the battery is first discharged resulting in a lower SOC. Later it is charged for a higher SOC. The charge and discharge is not correlated with curve 503 and is only for recovery and/or measurements of the selected batter module.

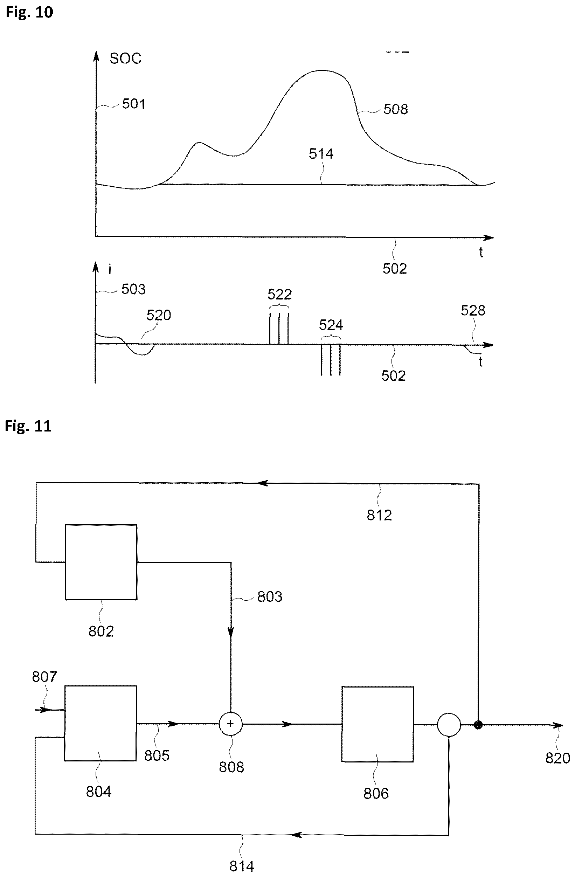

Fig. 10 shows a third exemplary SOC curve 514 of a selected battery module together with a curve indicating the current i 503 of the selected battery module. During step b) the SOC 514 of the selected battery module is approximately constant. Before and after step b) there is a common current 520, 528 for all battery modules including the selected battery module. During step b) the current through the selected battery module is approximately zero except for the intervals, where short positive and negative current pulses 522, 524 are fed through the selected battery module.

Fig. 11 shows an embodiment of a multilevel converter control. The control may be part of a controller. It may be implemented as software on a memory device and may be executed by a microcontroller or microprocessor. It may also be part of a control device. A multilevel converter 806 may be connected to a power grid 820 or any other load/source herein referred to as grid. The control further includes a grid voltage filter 802 and a current controller 804. The current controller 804 receives a measured grid current 814 and/or output current of the multi-level converter. It further receives a current set point 807 from which it generates a current controller output 805. The grid voltage filter 802 receives a measured grid voltage 812 and/or output voltage of the multilevel converter and generates a grid voltage estimate 803 including a direct component and its quadrature component. The direct component is added e.g., by a summing node 808 to the current controller output 805 and fed to the multilevel converter 806.

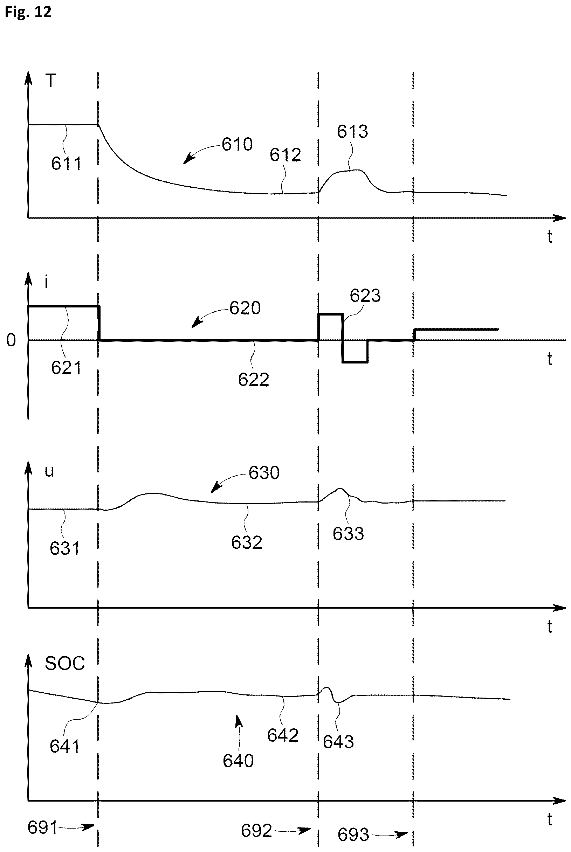

Fig. 12 shows a timing diagram of battery parameters when performing a test during a rest period. The diagram shows temperature 610, current 620, voltage 630 and SOC 640 of a battery. Temperature 610 of a battery module being in rest state may be monitored from the beginning of the rest state. The rest state begins at time 691 and ends at time 693. During the rest state, the temperature may decrease from an initial temperature 611 at an initial current 621, initial voltage 631 and initial SOC 641 to an ambient temperature 612 at zero current 622, further resulting in rest voltage 632 and a rest SOC 642. With the information from this cooldown temperature profile a thermal model e.g., a thermal equivalent circuit can be obtained.

As an additional step during this rest state one or more further rested battery modules can be put in a connected state for short time intervals, generating pulses with sequential positive and negative pulse currents 623. These may result in voltage response 633, thermal response 613, and SOC response 643. During the resting period and preferably after thermal equilibration at ambient temperature after a certain amount of time has passed during resting (cooldown) also positive and negative current pulses can be used to transfer a specific charge, the charge may be in sum also zero. This test may be repeated during different rest intervals with different SOCs of the battery. The pulses may be positive or negative in current while operation without negative effects to the MLC operation of the storage system. While one battery may be switched in serial positive another can be switched in serial negative resulting in a net zero voltage at the output of a string. This way two batteries can be examined in this way at the same time, though it is not necessary to pause the second battery for those negative and positive pulses. Therefore, also only one battery can be examined at a time.

From these current pulses 623 on the rested battery module(s) and the resulting voltage 633 response or thermal responses 613, equivalent circuits or battery parameters/characteristics/thermal inertia can be obtained. These can be used for deducting e.g., battery health and further usage (e.g., load or thermal balancing) of the battery in the storage system. States which may be detected are e.g., unusual thermal behavior, or too fast heating which may be caused by higher than usual internal resistance.

### List of reference numerals

- 100: battery storage system
- 110: first string
- 111- 113: battery modules of first string
- 114: first connector of first string
- 115: second connector of first string
- 120: second string
- 121 - 123: battery modules of second string
- 124: first connector of second string
- 125: second connector of second string
- 130: third string
- 131 - 133: battery modules of third string
- 134: first connector of third string
- 135: second connector of third string
- 141: first battery system connector
- 142: second battery system connector
- 150: communication bus
- 160: master controller
- 161: first string controller
- 162: second string controller
- 163: third string controller
- 164: first control bus
- 165: second control bus
- 166: third control bus
- 167: master control bus
- 170: backup master controller
- 177: backup master control bus
- 200: battery module
- 210: battery
- 220: series switch
- 230: parallel switch
- 240: first module connector
- 250: second module connector
- 260: module controller
- 261: series switch control line
- 262: parallel switch control line
- 263: battery signal line
- 270: bus connector
- 281: current direction - battery connected
- 282: current direction - short circuit
- 411-415: method steps
- 501: axis indicating SOC (state of charge)
- 502: axis indicating time
- 503: axis indicating selected battery's current
- 508: remaining batterie's SOC curve
- 510: selected battery module's first SOC curve
- 512: selected battery module's second SOC curve
- 514: selected battery module's third SOC curve
- 520, 528: current through all batteries
- 522, 524: current pulses through selected battery
- 610: temperature of battery over time
- 611: initial temperature
- 612: ambient temperature
- 613: test pulse temperature
- 620: current through battery over time
- 621: initial current
- 622: rest (zero) current
- 623: test pulse current
- 630: voltage of battery over time
- 631: initial voltage
- 632: rest voltage
- 633: test pulse voltage
- 640: state of charge (SOC) of battery over time
- 641: initial SOC
- 642: rest SOC
- 643: test pulse SOC
- 802: grid voltage filter
- 803: grid voltage estimate
- 804: current controller
- 805: current controller output
- 806: multilevel converter
- 807: current set point
- 808: summing node
- 812: measured grid voltage
- 814: measured grid current
- 820: grid

## Claims

1. A method of operating a battery storage system comprising at least one multilevel converter (110),
the at least one multilevel converter (110) comprising a plurality of battery modules (200),
each of the plurality of battery modules comprising at least one battery (210),
the at least one multilevel converter (110) being configured for multilevel converter mode including at least one of delivering electrical power by discharging at least one battery (210) and/or receiving electrical power by charging at least one battery (210),
the method comprising the steps of:
a) randomly selecting at least one battery module (200) for a rest out of the plurality of battery modules,
b) setting the at least one selected battery module (200) in rest state including a bypass state for a specified time interval between 1 second and 30 days or between 5 minutes and 20 days, while maintaining multilevel converter mode,
c) releasing the selected battery module (200) from the rest state including releasing the bypass state.

2. A method of operating a battery storage system comprising at least one multilevel converter (110),
the at least one multilevel converter (110) comprising a plurality of battery modules (200),
each of the plurality of battery modules comprising at least one battery (210),
the at least one multilevel converter (110) being configured for multilevel converter mode including at least one of delivering electrical power by discharging at least one battery (210) and/or receiving electrical power by charging at least one battery (210), by using a subset of the plurality of batteries,
the method comprising the steps of while operating the at least one multi-level converter (110) in multilevel converter mode:
a) randomly selecting at least one battery module (200) out of the subset,
b) removing the at least one selected battery module (200) from the subset for a specified time interval between 1 second and 30 days or between 5 minutes and 20 days, while maintaining multilevel converter mode with the battery modules (200) of the remaining subset,
c) re-inserting the selected battery module (200) into the subset and continuing maintaining multilevel converter mode with the battery modules (200) of the subset.

3. A method according to claim 1 or 2, the method comprising:
in step a) selecting a battery module (200) out of a group of battery modules which had
- no rest time during a specific time interval,
- lower rest time than other batteries,
- higher use than other batteries,
- lower SOH than other batteries.

4. A method according to any of the previous claims, the method comprising:
repeating the sequence of steps a) to c) until at least a predetermined number, 80%, 90% or 95% or all of the plurality of battery modules (200) has been selected.

5. A method according to any of the previous claims, the method comprising during or after step b) and before step c):
measuring of a battery voltage and/or battery temperature.

6. A method according to any of the previous claims, the method comprising during or after step a) and before step b):
Discharging or charging the selected battery module to a predefined SOC.

7. A method according to any of the previous claims,
**characterized in, that**
a step of predicting a next time window for executing step b) is executed before step b).

8. A method according to any of the previous claims, the method comprising during or after step b) and before step c):
interrupting the bypass state by switching the selected battery module (200) into a connected state for at least one short time interval to generate short positive or negative current pulses through a battery (210) in the battery. module (200).

9. A method according to any of the previous claims,
**characterized in, that**
the method is performed at the same time for multiple selected battery modules.

10. A method according to any of the previous claims,
**characterized in, that**
after entering the rest state, the temperature of the at least one selected battery module (200) is monitored and a thermal model of the at least one selected battery module (200) is calculated from the decrease in temperature, and/or
in rest state, the at least one selected battery module (200) may be put in a connected state for short time intervals, generating pulses with sequential positive and negative pulse currents, with one or more of those pulses resulting in net zero charge transfer, wherein a battery health and/or internal battery losses can be estimated from measured battery temperature and/or voltage values.

11. A method according to any of the previous claims, wherein the battery modules (200) comprise:
- a battery (210),
- a series switch (220) configured to connect or disconnect the battery (200) within the battery module, and
- a parallel switch (230) configured to bypass the battery module (200) when closed,
and wherein the battery modules (200) can be configured for:
- a connected state where the series switch (220) is open, and the parallel switch (230) is closed,
- a bypass state, where the series switch (220) is open, and the parallel switch (230) is closed.

12. A battery storage system (100) comprising at least one multilevel converter (110), the at least one multilevel converter (110) further comprising a plurality of battery modules (200), each battery module (200) includes at least:
- a battery (210),
- a series switch (220) configured to connect or disconnect the battery (200) within the battery module, and
- a parallel switch (230) configured to bypass the battery module (200) when closed,
wherein each battery module (200) can be configured for:
- a connected state where the series switch (220) is open, and the parallel switch (230) is closed,
- a bypass state, where the series switch (220) is open, and the parallel switch (230) is closed,
- an optional open state where the series switch (220) and the parallel switch (230) are open, and
wherein the battery storage system (100) and/or the at least one multi-level converter (110) is configured for performing a method according to any of the previous claims.

13. A control device for a multilevel converter including at least one multilevel converter system, the control device including a grid voltage filter 802 and a current controller 804,
the current controller 804 receiving a current set point 807 and a measured grid current 814 and/or output current of the multilevel converter, for generating a current controller output 805,
the grid voltage filter 802 receiving a measured grid voltage 812 and/or output voltage of the multilevel converter for generating a grid voltage estimate 803 including a direct component and its quadrature component, wherein the direct component is added to the current controller output 805 and fed to the multi-level converter 806.

14. A multilevel converter comprising a control device according to claim 13.

15. A battery storage system (100) comprising at least one multilevel converter according to claim 14.
